# EUROPEAN PATENT SPECIFICATION

(11) **EP 3 987 555 B1**
(45) Date of publication and mention of the grant of the patent: **22.05.2024**
(21) Application number: 20732811.3
(22) Date of filing: 10.06.2020
(51) Int. Cl.: H01F 6/02, G01R 33/3815, H01F 6/06, H01F 6/00

(54) **QUENCH PROTECTION FOR HIGH TEMPERATURE SUPERCONDUCTING (HTS) LEADS**
QUENCHSCHUTZ FÜR HOCHTEMPERATURSUPRALEITERZULEITUNGEN
PROTECTION DE QUENCH POUR LES CONNEXIONS SUPRACONDUCTRICES A HAUTE TEMPERATURE

(30) Priority: 20.06.2019 US 201962864037 P
(43) Date of publication of application: 27.04.2022
(73) Proprietor: Koninklijke Philips N.V., 5656 AG Eindhoven (NL)
(72) Inventor: VAN LANEN, Ezra, Petrus, Antonius, 5656 AE Eindhoven (NL); VOSS, Matthew, Jonathan, 5656 AE Eindhoven (NL); ROGERS, John, 5656 AE Eindhoven (NL); URBAHN, John, Arthur, 5656 AE Eindhoven (NL); PYNE, Alexander, James, 5656 AE Eindhoven (NL)
(86) International application number: PCT/EP2020/066005
(87) International publication number: WO 2020/254158

(56) References cited:
- WO-A1-2016/106037
- JP-A- H06 140 243
- JP-A- H10 154 616
- JP-B2- 2 723 351
- US-A1- 2019 108 933
- DAHLERUP-PETERSEN K ET AL: "The Quench Protection System for the LHC Test String 2", IEEE TRANSACTIONS ON APPLIED SUPERCONDUCTIVITY, IEEE SERVICE CENTER, LOS ALAMITOS, CA, US, vol. 14, no. 2, 1 June 2004 (2004-06-01), pages 251-254, XP011117331, ISSN: 1051-8223, DOI: 10.1109/TASC.2004.829063
- ROBIN D ET AL: "Superbend upgrade on the Advanced Light Source", NUCLEAR INSTRUMENTS & METHODS IN PHYSICS RESEARCH. SECTION A, ELSEVIER BV * NORTH-HOLLAND, NL, vol. 538, no. 1-3, 11 February 2005 (2005-02-11), pages 65-92, XP025295239, ISSN: 0168-9002, DOI: 10.1016/J.NIMA.2004.08.137 [retrieved on 2005-02-11]

## Description

### FIELD

The following relates generally to superconducting persistent magnets, and in particular, to a system and method for preventing damage to high temperature superconducting current leads in a superconducting persistent magnet for magnetic resonance imaging, and related arts.

### BACKGROUND

Magnetic resonance imaging (MRI) scanners commonly use a superconducting magnet to generate the static (B₀) magnetic field. The superconducting windings are typically constructed as superconducting fibers embedded in a copper matrix, and are immersed in liquid helium to maintain the windings at below the critical temperature for superconductivity at the operating electric current. The liquid helium is contained in a vacuum-jacketed cryostat with a cold head operated by a compressor maintaining the helium at cryogenic temperature (e.g. 4K or lower).

A disadvantage of this design is that some helium boil-off usually occurs, and the helium supply may occasionally need to be replenished. Moreover, if the magnet is brought up to room temperature to perform maintenance, the entire helium supply is usually lost and must be replenished.

Some more recent superconducting magnet designs employ a sealed cooling system that is charged with gas helium at elevated pressure (e.g. 1000 psi in some systems) and disposed in a vacuum cryostat. A cold head operates to cool the sealed cooling system to cryogenic temperature (e.g. 4K or lower), and the helium charge is at least partially liquefied at this low operating temperature. The magnet windings are in vacuum inside the cryostat and are outside of, but in thermal contact with, the sealed cooling system. Such "sealed" superconducting magnets are not prone to helium loss and use a much smaller helium charge compared with conventional superconducting magnet designs in which the magnet windings are immersed in liquid helium.

One potential disadvantage of sealed superconducting magnets is that they are more prone to quench due to a temporary loss of cold head function (for example, due to an electric power outage). However, modem superconducting magnet windings are capable of undergoing quench without damage due to the copper matrix providing high electrical conductivity when the superconducting fibers enter the normal state, together with winding designs that promote relatively uniform spread of the quench and heat dissipation from the point where quench initiates. In either the immersion or sealed superconducting magnet design, galvanic contact is made with the terminals of the superconducting windings in order to energize or deenergize the magnet. Ports in the cryostat are typically provided for this purpose, through which metal leads may be inserted to contact magnet terminals. This may produce a non-superconducting region (i.e., a region of normal conductivity) proximate to the point of galvanic contact due to heat transfer from the leads to the superconductor around the terminals of the superconducting windings. The electric current in this region of normal conductivity is carried by the copper matrix. Urbahn et al., WO 2017/178560 A1 published October 19, 2017 discloses an alternative design which employs high temperature superconducting (HTS) leads, for example made of an HTS material such as bismuth strontium calcium copper oxide (BSCCO), yttrium barium copper oxide (YBCO), or magnesium diboride (MgB2). The HTS leads have a critical temperature for superconductivity of 25K to as high as 90K or higher depending upon the HTS material and the electric current magnitude. The HTS leads advantageously provide a smoother transition from room temperature outside the cryostat to the 4K or lower temperature of the superconducting magnet windings. JP H06 140243 A describes that a current lead is composed of a high temperature side lead with a current lead, made of good conductive metal, with which the exciting current sent from an external power source is applied to the superconducting coil which is housed in a vacuum heat insulating container and maintained at a cryogenic temperature. Further, a low-temperature side lead consisting of oxide superconducting material is provided, and a material which is series-connected to the intermediate connection fitting, to be connected to the intermediate connection fitting, to be used to connect both of the above-mentioned leads, and cooled by low temperature refrigerant gas GHe. The abnormal conduction and the abnormal temperature of the low temperature side lead are detected by a potentional difference detector and a temperature detector, and an abnormality protecting device, which instructs the breaking of a circuit breaker, is provided on a judgement part. From JP 2 723351 B2 it is known to contrive to secure a stable operation without stopping the operation of a superconductive device even in the case of an abnormality by providing at least one of a superconductive power cable and current supply lead with a quench detector and by interlocking the detector with a permanent switch installed at the superconductive device. When any trouble occurs in a superconductive power cable so that a partial superconductive destruction takes place, the permanent switch of a superconductive device is operated via a quench detector. Further, the signal of the quench detector is used for operating a switch provided in a room temperature atmosphere to stop the transmission of electrical energy from a power supply. Then, the Joule heating in the normally conducting part of the superconductive power cable and current supply lead are eliminated, said part is cooled by a coolant intervening around it and the superconductively destructed part is restored to a superconductive state. When the trouble of the superconductive power cable is removed, the quench signal of the quench detector stops, the switch operates in the manner of working with the stop of the signal and electricity is again transmitted from the power supply. WO 2017/178560 A1 further discloses that a sealed electrical feedthrough passes through the cryogenic container. A normally-open contactor inside the cryogenic container has an actuator and feedthrough-side and magnet-side electrical terminals. The high temperature superconductor (HTS) lead also disposed in the cryogenic container has a first end electrically connected with the magnet-side electrical terminal of the contactor and a second end electrically connected to the superconducting magnet winding. A first stage thermal station thermally connected with the first end of the HTS lead has a temperature lower than the critical temperature (TC, HTS) of the HTS lead. A second stage thermal station thermally connected with the second end of the HTS lead has a temperature lower than a critical temperature of the superconducting magnet winding.

The following discloses certain improvements to overcome these problems and others.

### SUMMARY

The invention is defined in the independent claims. Preferred embodiments are described in the dependent claims. In one aspect, an apparatus includes a cryostat containing a volume of cryogenic fluid. One or more electrically superconducting coils is disposed within the cryostat. The one or more electrically superconducting coils is configured to produce a magnetic field when an electrical current is passed therethrough. One or more high temperature superconducting (HTS) current leads is permanently disposed within the cryostat and coupled to the one or more electrically superconducting coils. One or more sensors is positioned at or near the one or more HTS current leads to monitor the status of the HTS current leads. An HTS protection switch is selectively coupled to the one or more HTS current leads. A magnet controller controls the HTS protection switch to divert current from the one or more HTS current leads upon detection via the sensors of a quench of the one or more HTS current leads.

In another aspect, an apparatus for a medical imaging device includes at least one superconducting current lead. At least one voltage sensor is configured to measure a voltage in the at least one superconducting lead. A protection switch is operative to divert electrical current from the at least one superconducting current lead. Electronics are configured to control the protection switch to break the electrical power circuit in response to a break condition including the voltage sensor detecting a voltage in the at least one superconducting lead exceeding a break threshold.

In another aspect, a method of protecting high temperature superconductor (HTS) leads in a medical imaging device from quenching includes: measuring a voltage across at least one HTS lead; determining whether the measured voltage is outside of a corresponding predefined threshold; and severing a connection between the at least one HTS lead and electronics of the medical imaging device when the measured voltage is outside of the predefined threshold.

Some illustrative embodiments disclosed herein solve the problem of requiring specialized personnel travel to the site of the superconducting magnet by having a power supply and current leads permanently installed. Control equipment monitors the cryogenic conditions inside the magnet, and uses a decision tree to decide to automatically de-energize the magnet, or automatically energize it back up to nominal field. In addition, a user interface is provided to allow an authorized user (e.g., an operator) to automatically de-energize the magnet, or automatically energize it back up to nominal field when needed or otherwise desired.

For example, energizing conventional magnets requires the presence of service personnel and specialized equipment. If a magnetized foreign object (e.g. patient bed or floor buffer) is stuck to the magnet, the time and cost to remove the object from the magnet can be a considerable burden for the user (e.g. hospital, clinic, etc.). For newer type "sealed" magnets, which have only a fraction of the original helium inventory, automatically energizing the magnet becomes even more desirable. Contrary to the helium bath type magnets, the small helium inventory can only support a cooling failure for a few hours. After that, residual heat that has travelled into the cryostat has increased the coil temperature to the point that superconductivity is no longer sustained and the magnet "quenches" (thermal runaway causing rapid decay of field and increase of coil temperature). It is unlikely that service personnel can reach the site in time, and prepare the magnet for de-energizing. With automatic ramping or user-initiated ramping (e.g. energizing, de-energizing), this state can be prevented by releasing the magnet's energy to an external dump. A cooling failure may occur due to a power outage at the site of the MRI scanner. After the power is restored, the automatic power supply can energize the magnet again without need for human intervention. Likewise, a user may initiate de-energization of the magnet when a foreign object is stuck to the magnet or any other desired purpose. When the foreign object is cleared from the magnet or the user determines it is desirable to re-energize the magnet, the user may initiate energization of the magnet. This maximizes the up-time, and as a result increases the value of the system to the customer.

One advantage resides in protecting HTS leads of a superconducting magnet in the event of a quench of the HTS leads.

Another advantage resides in preventing quenching of HTS leads of a superconducting magnet.

Another advantage resides in reducing maintenance time and costs by preventing damage to HTS leads

Another advantage resides in diverting current from HTS leads to prevent quenching of the leads or, if an HTS quench occurs, to prevent damage to the HTS leads.

Another advantage resides in providing a MRI device employing a superconducting magnet with one or more of the foregoing advantages.

A given embodiment may provide none, one, two, more, or all of the foregoing advantages, and/or may provide other advantages as will become apparent to one of ordinary skill in the art upon reading and understanding the present disclosure.

### BRIEF DESCRIPTION OF THE DRAWINGS

The disclosure may take form in various components and arrangements of components, and in various steps and arrangements of steps. The drawings are only for purposes of illustrating the preferred embodiments and are not to be construed as limiting the disclosure.
FIGURE 1 illustrates an exemplary embodiment of a magnetic resonance imaging (MRI) apparatus.
FIGURE 2 illustrates an exemplary embodiment of a superconducting magnet system which may be employed in an MRI apparatus in accordance with aspects of the present invention.
FIGURE 3 shows another embodiment of the system of FIGURE 2 which does not form part of the present invention.
FIGURE 4 shows exemplary flow chart operations of the systems of FIGURES 2 and 3.

### DETAILED DESCRIPTION

HTS leads offer advantages over other schemes as an electrical connection between portions of a magnet that operate at cryogenic, but different, temperatures. The low-to-zero electrical resistance of an assembly incorporating HTS significantly reduces ohmic heating when used to carry currents between magnet portions, while the high thermal resistance reduces the heat transfer between those portions.

On the other hand, Low-temperature-superconductor (LTS) leads, such as those used in superconducting magnet windings, employ superconducting metallic filaments inside a copper matrix. When a critical temperature of these filaments is exceeded (e.g., the filaments "quench"), the surrounding copper matrix begins to conduct electricity, shunting current around the now-resistive (normal) filament portions. This prevents permanent damage to the delicate filaments as ohmic heating in the filaments is reduced, and any heat generated is quickly conducted away from the normal zone through the copper.

In contrast, HTS components are typically a superconducting ceramic material bonded to comparatively minimal metallic volumes. Therefore, the current shunted around the normal zone and the heat carried away from the normal zone during a quench are often insufficient to prevent permanent damage to the delicate ceramic. Depending on what electrical currents the HTS is carrying during this quench, permanent damage to the HTS can occur within hundreds of milliseconds.

The situation is to be distinguished from the case of the superconducting magnet winding which has a copper matrix providing a low (albeit finite) electrical resistance if the superconducting fibers enter the normal state; by contrast, the HTS material is typically a ceramic which exhibits a high electrical resistance and cannot take the electrical current load if the HTS lead quenches. Hence, the HTS lead may rapidly suffer irreparable damage, e.g. within one second of quench initiation, and in practice likely much faster than this, e.g. 100 msec or a few hundred msec.

Disclosed herein are persistent superconducting magnets that have energizing current leads permanently installed and connected to a power supply. The temperature of the coil's magnet needs to stay below a cryogenic temperature to maintain superconductivity. The permanent electrical connection between the superconducting coils and the outside world minimize the heat leaking from the outside to the superconducting coils. In addition, they should not produce too much Joule heating (ohmic heating) while carrying current, or else the heat drives the coils out of superconductivity.

Disclosed herein are persistent superconducting magnets that employ HTS lead assemblies as part of an electrical connection between the superconducting coils and equipment outside the magnet's vacuum space. Specifically, the HTS is used to carry high (hundreds of amps) current between the LTS coils and higher-temperature (i.e. LTS-prohibiting, but HTS-accommodating) portions of the magnet.

HTS Rare Earth Barium Copper-Oxide (ReBCO) leads are used instead because they cover both areas; they can carry high current without Joule loss up to much higher temperatures, and they can be manufactured with a particularly low thermal conductivity. For further reduction of heat leak into the magnet, mechanical switches (thermal switches) are installed inside the magnet between the HTS current leads and the external current terminals. These switches are only closed if current is required to flow through the HTS leads, otherwise they are open. HTS is well suited to this application. The heat transferred to the LTS from the higher-temperature magnet regions, and from ohmic heating within the HTS, is small enough that the LTS can remain at superconducting temperatures during the various magnet operating modes.

According to the invention, an automated current shutoff system is provided for abruptly breaking electric current in the case of an incipient HTS lead quench. The systemmay include voltage sensors at opposite ends of the HTS lead which are electrically connected with rack-mounted electronics including a differential voltage meter with high common mode rejection capability. If the measured differential voltage across the HTS lead exceeds some threshold (e.g. 50 mV in one embodiment; note this voltage is theoretically identically zero for the HTS lead in the superconducting state) then an actuated (e.g. solenoid driven) cutoff switch is opened to break the current. In variant embodiments, the current shutoff logic includes a noise delay, low pass filter, or the like to avoid unnecessary current shutoff due to noise. In some embodiments the electronics are all analog (e.g. using analog op amp circuits) so as to be insensitive to computer glitches. While one HTS lead is described above, both HTS leads are preferably analogously monitored and the current shutoff switch is thrown if either HTS lead exhibits voltage over the triggering threshold thus indicating incipient quench of the HTS lead. The term "incipient quench" as used herein is intended to denote the HTS lead or portions thereof transitioning from the superconducting state to the normal state or having just transitioned to the normal state, but before the resultant Joule heating has reached a level sufficient to damage the HTS lead.

Superconducting materials exhibit very low (theoretically, zero) resistance. Therefore, notable voltage generated across HTS carrying current indicates that some part of the HTS has quenched. The system monitors the voltage across all assemblies containing HTS and electrically opens the current loop containing any HTS generating voltage above a threshold. This prevents further heating within that HTS and damage. The low differential-mode (tens of millivolts) and high-common mode voltages (hundreds of volts) of these measurements are of note. In some variants, this monitored voltage is passed through a noise filter (e.g. a low-pass filter or time delay) to prevent nuisance trips. In some variants, this protection system is implemented entirely in analog (i.e. with no software) circuitry for the sake of immunity to computing glitches.

In other embodiments disclosed herein, a temperature sensor (e.g. thermistor or temperature sensitive diode) is provided. Temperature can be a lagging indicator compared with differential voltage, and reliance upon detection of a temperature rise of the HTS lead for triggering the electric current cutoff switch could be too slow to prevent damage to the HTS leads. A temperature sensor at the hot end of the HTS lead (that is, near the connection with the galvanic lead) is useful to implement less aggressive remediation, such as lowering the magnitude of the electric current in response to the HTS temperature at the hot end approaching the critical temperature (Tc). Lowering the electric current increases Tc (since it is dependent on electric current magnitude) and may also reduce the (rate of) temperature rise if it is due to Joule heating of the metallic conductor connected with the HTS lead.

In some embodiments disclosed herein, an automated system is provided to prevent the HTS from quenching due to temperature. This system monitors the temperature of all assemblies containing the HTS and adjusts system electrical currents to levels safely within the critical current that corresponds to the measured temperature. Note - temperature increase of an HTS assembly due to ohmic heating within the ceramic is a lagging indicator of a quench, and is unlikely to provide response time adequate to prevent damage to quenching HTS.

A system is disclosed herein to actively prevent damage to the HTS current leads in the event of thermal runaway when they carry current. These current leads are permanently installed inside the magnet's cryostat, and can only be replaced by de-installing the magnet from its site and returning the magnet to the factory where it was built or similar facility.

These systems are implemented to prevent damage to HTS portions of the magnet. Repairing or replacing assemblies using HTS within a magnet requires returning the magnet to its factory or similar facility, specialized labor, and considerable time, making it highly undesirable.

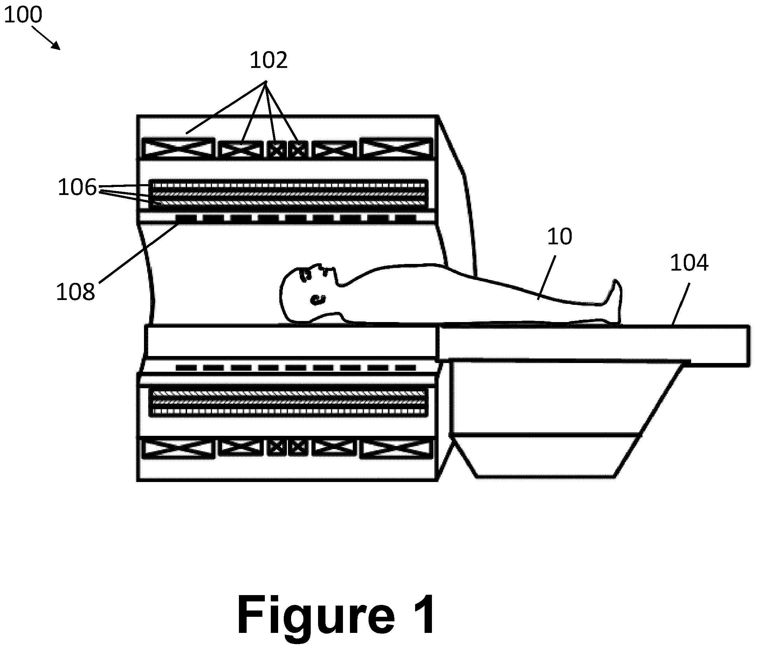

FIGURE 1 illustrates one exemplary embodiment of a magnetic resonance imaging (MRI) apparatus **100.** MRI apparatus **100** can include, for example, a magnet **102;** a patient table **104** configured to hold a patient **10;** gradient coils **106** configured to at least partially surround at least a portion of patient **10** for which MRI apparatus **100** generates an image; a radio frequency coil **108** configured to apply a radio frequency signal to at least the portion of patient **10** which is being imaged, and to alter the alignment of this magnetic field; and a scanner configured to detect changes in the magnetic field caused by the radio frequency signal. The general operation of an MRI apparatus is well known and therefore will not be repeated here.

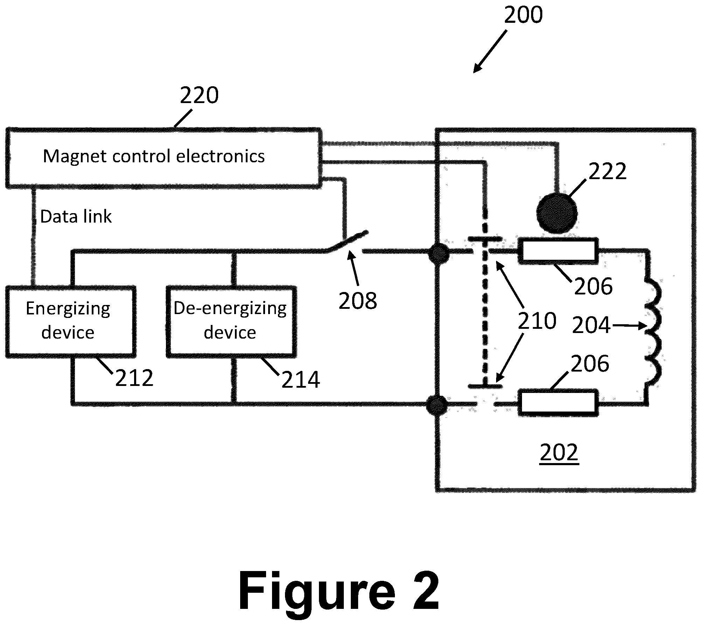

Referring to FIGURE 2, an exemplary system or apparatus **200** is illustrated. The system **200** includes a cryostat **202,** which is a vacuum vessel containing the superconducting coils (also referred to as windings) **204,** a closed cooling system (not shown) with a small amount of cryogenic fluid (e.g., helium) and other components to operate the magnet. The one or more electrically superconducting coils **204** are disposed within the cryostat **202,** wherein the one or more electrically superconducting coils **204** is configured to produce a magnetic field when an electrical current is passed therethrough.

The cryostat **202** is further configured to house one or more high temperature superconducting current leads (i.e. one or more HTS leads) **206.** The high temperature superconducting current leads **206** are permanently disposed within the cryostat and coupled to the one or more electrically superconducting coils **204.** The one or more high temperature superconducting current leads **206** are formed from Rare earth-Barium-Copper Oxide (ReBCO). High temperature superconducting (HTS) ReBCO leads are used instead of conventional leads because they can carry high current without Joule loss up to much higher temperatures, and they can be manufactured with a particularly low thermal conductivity, thereby minimizing any heat transfer from the ambient of the atmosphere into the temperature sensitive superconducting coils.

A high temperature superconducting protection switch (i.e. HTS protection switch) 208 selectively couples to the one or more high temperature superconducting current leads and external devices (e.g., energizing device **212,** de-energizing device **214).** The high temperature superconducting protection switch **208** is preferably disposed outside the cryostat **202.** The high temperature superconducting protection switch **208** is in a first state (i.e. open) the one or more electrically superconducting coils **204** are in a persistent state and when the high temperature superconducting protection switch **208** is in a second state (i.e. closed), the high temperature superconducting current leads **206** are configured to energize or de-energize the one or more electrically superconducting coils **204.** According to the invention, thermal switches **210** are configured to electrically couple the one or more high temperature superconducting current leads **206** to devices (e.g., energizing device **212,** de-energizing device **214)** disposed outside the cryostat. As seen in FIGURE 2, the high temperature superconducting protection switch **208** must also be closed in order to electrically couple the energizing and de-energizing devices **212, 214** to the high temperature superconducting current leads **206;** put another way, if either the protection switch **208** or the thermal switches **210** are open then the energizing and de-energizing devices **212, 214** are electrically decoupled from the high temperature superconducting current leads **206).** According to the invention, the thermal switches **210** are latching thermal switches. In one embodiment, the first state is an open state and the second state is a closed state.

The system **200** includes a magnet controller **220,** which generally controls and/or monitors the various components of the system, including controlling the state of the high temperature superconducting protection switch **208.** For example, the magnet controller **220** is coupled to voltage and temperature sensors **222,** which are disposed at or near one or more of the high temperature superconducting current leads **206,** the energizing device **212,** and the de-energizing device **214).** Such voltage and temperature sensors are configured to monitor the status of the high temperature superconducting current leads **206.**

The magnet controller **220** monitors signals from the one or more sensors **222** of the system **200.** The magnet controller **220** may determine, for example, by analyzing the signals from the one or more sensors **222,** whether or not a fault or malfunction is detected. In particular, the magnet controller **220** may determine whether a fault or malfunction indicating that a quench is occurring or may be impending. If the magnet controller **220** detects a fault or malfunction in the system **200,** particularly a fault or malfunction which indicates that a quench of the superconducting coils **204** is or may be impending, the magnet controller **220** connects the high temperature superconducting protection switch **208** from the persistent state to a second state to divert current from the high temperature superconducting leads **206** to the energy dump unit (de-energizing unit) **214,** which is located outside of or external to the cryostat, across the opposite end of the electrically conductive coil of the superconducting magnet via the pair of high temperature superconducting leads **206.**

The magnet controller **220** monitors the one or more fault conditions. In operation, the magnet controller **220** determines, for example, by analyzing the one or more sensor signals **222,** whether or not a fault or malfunction condition has been corrected. If the fault has been corrected so that the superconducting coils **204** are no longer at risk for quench, the magnet leads are uncoupled from the energy dump unit **212** and are coupled to the energizing device **212** in order to return the electrically superconducting coils to the persistent state. Once the electrically superconducting coils **204** are at or near persistent state, the high temperature superconducting protection switch, and the one or more high temperature superconducting current leads are switched to the persistent state. Operation of the system **200** proceeds in the persistent state until the magnet controller **220** detects a fault or malfunction in the magnet system, as described above.

By this process, a quench within the cryostat **202** and damage to the high temperature superconducting current leads **206** may be prevented, thereby avoiding damage to the cryogenic materials and/or the electrically superconducting coils **204.**

One aspect of the current invention applies to persistent superconducting magnets that have energizing current leads permanently installed and connected to a power supply. The temperature of the coil's magnet needs to stay below a cryogenic temperature to maintain superconductivity. The permanent electrical connection between the superconducting coils and the outside world are required to enable energizing and de-energizing of the magnet automatically without the need for intervention of field service personnel. In addition, they cannot produce too much Joule heating (ohmic heating) while carrying current, or else the heat drives the coils out of superconductivity. For further reduction of heat leak into the magnet, mechanical switches (thermal switches) are installed inside the magnet between the HTS current leads and the external current terminals. These switches are only closed if current is required to flow through the HTS leads, otherwise they are open.

Another problem (i.e. failure mode) addressed herein is that if the high temperature superconducting current leads **206** are driven into normal state (quench) for any reason while they carry current, damage from Joule heating may render them inoperable. Another failure mode is that if any of the thermal switches **210** are opened while it carries current, an arc will cause damage to its contacts, and it will need replacement as well. The problem is that both the high temperature superconducting leads **206** and the thermal contactors are inside the vacuum of the sealed cryostat **202.** Therefore, repair work can only be done at a dedicated location such as their factory of origin or similar facility. This causes considerable cost and inconvenience to the user due to down-time of the MRI scanner, as well as the renovation work needed to replace the magnet.

As described above, the embodiment of FIGURE 2 includes additional hardware 222 and control software to monitor the status of the high temperature superconducting leads **206,** and diverts the current from the HTS leads **206** by opening the HTS protection switch **208** as soon as a quench of the HTS is detected. This may lead to a quench of the magnet itself (that is, of the superconducting coils **204),** but a passive quench protection circuit (not shown) inside the magnet guarantees that Joule heating does not cause damage to the internal components of the magnet. In case of high temperature superconducting quench detection, the energizing controls also immediately turn off the power supply, and the current in the high temperature superconducting current leads **206** between the magnet and the power supply is almost immediately removed via HTS protection switch **208.**

According to the invention, the thermal switch(es) **210** are latching. They only need an electrical pulse to switch between opened and closed state or vice versa. This means that the switches will remain closed if the MRI site experiences a power outage when the magnet is energizing or de-energizing. The control software further ensures that these contactors cannot be opened when they carry current. The latching operation of the switches **210** ensure that the switches **210** do not change their state (whether open or closed) in response to a power outage. Hence, if the switches **210** are closed and carrying electric current at the time of a power outage, the switches **210** will remain closed. By contrast, if non-latching normally-open solenoid-driven switches were to be used, then loss of electrical power during the power outage would result in electric current to the solenoid being lost causing the switch to revert to its normally open state, potentially leading to an electric arc that could cause damage to the HTS leads **206** and/or other components in the electric circuit.

Conversely, if non-latching normally-closed solenoid-driven switches were to be used, then loss of electrical power during the power outage would result in the switches closing potentially creating an undesired short-circuit. The latching switches **210,** on the other hand, hold their current state (either open or closed) unless and until an electrical pulse is sent to the latching switches **210** by the magnet control electronics **220,** thereby causing the latching switches **210** to switch state (either from open to closed, or from closed to open). The control software suitably ensures the latching switches **210** cannot be opened when they carry current - for example, the magnet control electronics **220** may include an ammeter measuring the electric current in the circuit flowing to/from the latching switches **210** and only sends an electric pulse to switch latch state of the latching switches **210** if the measured current is zero.

In another embodiment of this invention, software for processing the signals and sending commands to open and close the HTS protection circuit is provided. In addition, control of the magnet controller may occur on-site at the MR scanner or remotely from a computer communicatively coupled to one MR scanner through a network (e.g., Internet, Cloud, remote server, service provider, etc.).

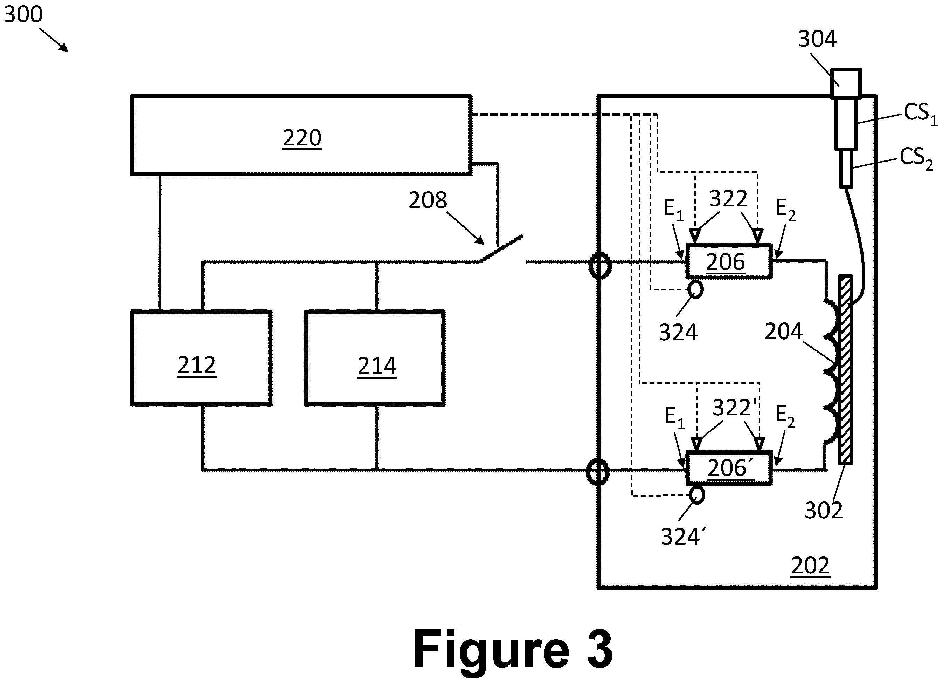

FIGURE 3 illustrates a more detailed embodiment of a superconducting magnet 300 of a medical imaging device (e.g., the MRI apparatus **100** of FIGURE 1) in accordance with another aspect that does not form part of the present invention. It will be appreciated that components common to both FIGURES 2 and 3 will contain "like" reference characters between the figures, and thus descriptions of these common components will not be repeated for brevity and conciseness. As shown in FIGURE 3, the superconducting magnet **300** includes the cryostat **202** which is a vacuum vessel containing the superconducting coils **204** and a closed cooling system **302** that contains a small volume of cryogenic fluid (e.g. helium). A cold head **304** driven by a compressor (not shown) operates to cool the helium in the closed cooling system **302** to around 4K or lower. The illustrative cold head 304 is a two-stage cold head having a first cold station **CS₁** and a second cold station **CS₂,** where the second cold station **CS₂** is colder (e.g. at around 4K or lower) than the first cold station **CS₁** (e.g. at a few tens of Kelvin typically). The at least one electrically superconducting coil **204** is disposed within the cryostat **202** in thermal contact with the closed cooling system **302** so as to also be cooled to the around 4K or lower cryogenic temperature, and is configured to produce a magnetic field when an electrical current is passed therethrough.

FIGURE 3 also shows an apparatus for preventing quenching of leads in the MRI apparatus **100.** The apparatus includes the at least one HTS lead **206, 206'** (e.g., a first HTS lead **206,** and a second HTS lead **206');** the voltage and temperature sensors **222** of FIGURE 2 are shown separately in FIGURE 3 as at least one voltage sensor **322** monitoring the first HTS lead **206,** at least one voltage sensor **322'** monitoring the second HTS lead **206',** at least one temperature sensor **324** monitoring the first HTS lead **206,** and at least one temperature sensor **324'** monitoring the second HTS lead **206';** the HTS protection switch **208,** and magnet control electronics **220.** Signal connections of the various sensors **322, 322', 324, 324'** to the electronics **220** are diagrammatically indicated in FIGURE 3 by dashed lines - these signal connections may be physically implemented as wired or wireless connections. The at least one HTS lead **206, 206'** is disposed within the cryostat **202** and coupled to the at least one electrically superconducting coil **204.** As shown in FIGURE 3, the first HTS lead **206** is disposed at a first "top" end of the at least one electrically superconducting coil **204** and the second HTS lead **206'** is disposed at a second "bottom" end of the at least one electrically superconducting coil.

Each HTS lead **206, 206'** has a first end labeled **E₁** which is galvanically connected with a metallic conductor (e.g. copper, aluminum, an alloy thereof, or so forth) and an opposite second end labeled **E₂** which is galvanically connected with a terminal of the superconducting winding **204.** In general, the second ends **E₂** are at or near the operating temperature of the superconducting winding **204,** that is, at around 4K or lower in temperature. By contrast, the first ends **E₁** are at a substantially higher temperature, for example a few tens of Kelvin to around 70K to 80K depending on the detailed configuration. In a suitable approach, the first cold station **CS₁** of the cold head **304** is thermally connected with the first ends **E₁** or with the corresponding galvanically connected metallic conductors in order to assist in maintaining the first ends **E₁** at the desired temperature. Note, FIGURE 3 does not illustrate the thermal connection with cold station **CS₁**. In a typical arrangement such as that described in WO 2017/178560, a thermal shield (not shown) surrounds the cold closed cooling system **302** and superconducting windings **204** and is in thermal contact with the first cold station **CS₁** to keep the thermal shield at a temperature of around 100K or lower, and the thermal shield provides (at least part of) the thermal path between the first ends **E₁** and the cold station **CS₁**. As shown in FIGURE 3, a first end of the first HTS lead **206** is operatively connected to the protection switch **208,** and a second end of the first HTS lead **206** is operatively connected to one terminal of the at least one superconducting coil **304.** The first end **E₁** of the second HTS lead **206'** is operatively connected to the energizing/deenergizing device **212, 214,** and the second end **E₂** of the second HTS lead **206'** is operatively connected to another terminal of the at least one superconducting coil **304.**

The at least one voltage sensor **322, 322'** is configured to measure a voltage in the at least one HTS lead **306, 306'.** In illustrative FIGURE 3, each voltage sensor **322, 322'** is a differential voltage sensor configured to measure a differential voltage across the respective HTS lead **206, 206'.** As further shown in FIGURE 3, the at least one voltage sensor **322, 322'** includes a first differential voltage sensor **322** configured to measure differential voltage across the first HTS lead **206** and a second differential voltage sensor **322'** configured to measure differential voltage across the second HTS lead **206'.** Each illustrative temperature sensor **324, 324'** is arranged to measure the temperature of the first end **E₁** of the respective HTS lead **206, 206'.** This position for the temperature sensor is chosen because as explained above, the first end **E₁** of each HTS lead is expected to be at higher temperature than the second end **E₂** of the HTS lead - thus, as long as the first end **E₁** is under the critical temperature T_{c} for superconductivity it follows that the entire HTS lead should be under the critical temperature T_{c}.

As shown in FIGURE 3, the protection switch **208** is disposed outside of the cryostat **202.** The protection switch **208** is operative to divert electrical current from the at least one HTS lead **206, 206'.** In other words, the protection switch **208,** when opened, operates to break the electrical current path from the energizing/deenergizing device **212, 214** to the least one superconducting coil **204.**

The electronics **220** are configured to control the protection switch **208** to break the electrical power circuit in response to a break condition. The break condition can include the at least voltage sensor **322, 322'** detecting a voltage in the at least one HTS lead **206, 206'** exceeding a break threshold. To do so, when the at least one differential voltage sensor **322, 322'** measures the differential voltage across the at least one HTS lead **206, 206',** the electronics **220** detect whether the magnitude of the measured differential voltage is increased above a predetermined voltage threshold (e.g., 50 mV). When this condition occurs, the electronics **220** are configured to open the protection switch **208** to divert the electrical current from the at least one HTS lead **206, 206'.** In one example, the electronics **220** detect the magnitude of the differential voltage as increased above the predetermined voltage threshold if the magnitude of the differential voltage after filtering by a low pass filter is above the predetermined voltage threshold. In another example, the electronics **220** detect the magnitude of the differential voltage as increased above the predetermined voltage threshold if the magnitude of the differential voltage is above the predetermined voltage threshold for a predetermined time interval.

Such approaches reduce the likelihood of noise causing the HTS protection switch 208 to be thrown and unnecessarily breaking the electrical power circuit potentially leading to a quench of the superconducting windings **204.** If the predetermined time interval is used, it should be chosen to be short enough to ensure that the current will be broken before the HTS leads **206, 206'** can be damaged by Joule heating. In general, the predetermined time interval is expected to be 1 second or lower, and more preferably 100 milliseconds or lower; the choice of the predetermined time interval should take into account any time latency in actuating the opening of the HTS protection switch **208** and other factors such as the HTS type, length, geometry, and so forth. Similar considerations are apropos in selecting the time constant or transient behavior of a low pass filter used to reject noise - its response time should be sufficient to avoid damage to the HTS leads due to Joule heating.

In some examples, at least one temperature sensor **324, 324'** detect a temperature of the at least one HTS lead **306, 306'.** If the temperature exceeds a threshold, the electronics **322** can open the protection switch **308** to divert the electrical current from the at least one HTS lead **306, 306'.** However, as noted previously, since temperature tends to be a lagging indicator of quench compared with the differential voltage, more preferably the temperature sensors are not used to trigger opening of the HTS protection switch **208** (or at least are not relied upon as the primary trigger for this). Rather, in some preferred embodiments the temperature sensors **324, 324'** are used to trigger less aggressive remedial action when the temperature at one or both first ends **E₁** begins to approach the HTS superconducting temperature T_{c}. For example, the remedial action may be to reduce the electric current magnitude flowing through the HTS leads **206, 206'** by control of the operating energizing or deenergizing device **212, 214.** This will reduce the Joule heating in the metallic conductors galvanically connected with the first ends **E₁**, and also increases the HTS superconducting critical temperature T_{c} which usually decreases with increasing electric current amplitude.

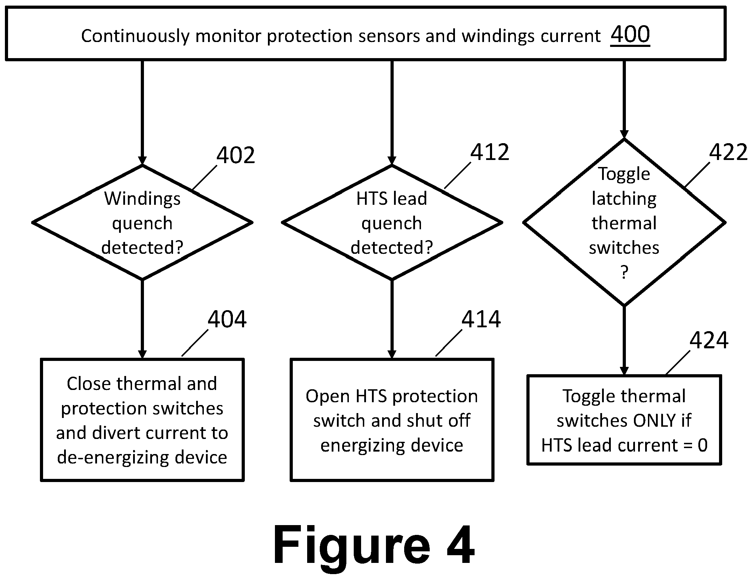

With reference to FIGURE 4, an illustrative embodiment of a magnet protection method is shown. At **400,** the various protection sensors (e.g. sensors **222, 232, 232', 234, 234')** and the current in the superconducting windings **204** are monitored. At **402,** if a quench of the magnet windings **204** is detected (e.g. by detection of a nonzero voltage across the terminals of the magnet windings **204),** then, at **404** the electronics **220** operate to close the switches **208, 210** (if they are not already closed) and to connect the de-energizing device **214** so as to divert the persistent electric current in the windings **204** to the de-energizing device **214** in order to perform a controlled magnet shutdown (to the extent possible insofar as quench is already underway; however, the passive quench protection circuit of the windings **204** including the copper matrix of the windings provides protection against damage to the coils during quench of the windings). It should be noted that this fault pathway is triggered by the windings **204** rising above around 4K - hence, there is little likelihood that this will trigger a quench of the HTS leads **206, 206'** as their T_{c} is on the order of a few tens of Kelvin. Additionally, the HTS protection monitoring may also optionally employ the temperature sensors **324, 324'** to detect a rising temperature of a first end **E₁** and take less aggressive remediation as previously described; this is not depicted in FIGURE 4.

In a different possible fault condition (shown at **412),** an incipient quench of one or both HTS leads **206, 206'** is detected, e.g. based on a voltage measured across the at least one HTS lead **206, 206'** by the at least one voltage sensor **222, 222'.** In this case, at **412,** the electronics **220** are configured to determine whether the measured voltage (which may be a differential voltage as previously described) is outside of a corresponding predefined threshold. If so, then at **414,** the electronics **220** operate to interrupt the electrical current flowing in the at least one HTS lead **206, 206'** by opening the HTS protection switch **208** when the measured voltage is outside of the predefined threshold. This may result in quench of the magnet windings **204,** as previously noted; however, it is recognized herein that quench of the windings usually does not result in damage to the windings, and is preferable to uncontrolled Joule heating of the HTS leads which is very likely to lead to expensive damage to the HTS leads.

In another possible fault condition (shown at **422),** a call for toggling the latching thermal switches **210** is generated. Such a call may be generated automatically by the electronics **220,** or manually by a user. In this case, at **424,** the call to toggle the latching thermal switches **210** is executed only if the amplitude of the electric current in the HTS leads **206, 206'** is zero (or, to simplify implementation, is below some threshold). This ensures that the switches **210** are not opened while carrying electric current thereby producing a damaging electric arc. It may be noted that this fault remediation path **422, 424** does not interfere with either the windings quench remediation path **402, 404** or the HTS leads quench remediation path **412, 414** for the following reasons. First, if the latching switches **210** are in the open state then the current is going to be zero, and hence the remediation path **422, 424** can never prevent toggling the latching switches **210** from the open state to the closed state. Next, if the latching switches **210** are in the closed state and a windings quench is detected at **402,** then the operation **404** will not call for toggling the latching switches **210** because they are already closed. Finally, if the latching switches **210** are in the closed state and an HTS lead quench is detected at **412,** then the remedial operation is to open the HTS protection switch **208** which does not generate a call to toggle the latching switches **210.**

The disclosure has been described with reference to the preferred embodiments. Modifications and alterations may occur to others upon reading and understanding the preceding detailed description. It is intended that the exemplary embodiment be construed as including all such modifications and alterations insofar as they come within the scope of the appended claims.

## Claims

1. An apparatus **(200),** comprising:
a cryostat **(202)** containing a volume of cryogenic fluid;
one or more electrically superconducting coils **(204)** disposed within the cryostat, wherein the one or more electrically superconducting coils is configured to produce a magnetic field when an electrical current is passed therethrough;
one or more high temperature superconducting, hereinafter HTS, current leads (206) permanently disposed within the cryostat and coupled to the one or more electrically superconducting coils;
one or more sensors **(222)** positioned at or near the one or more HTS current leads and configured to monitor the status of the HTS current leads;
a HTS protection switch **(208)** for protecting the one or more HTS current leads, selectively coupled to the one or more HTS current leads;
a magnet controller **(220)** configured to control the HTS protection switch;
wherein the magnet controller is configured to control the HTS protection switch to divert current from the one or more HTS current leads upon detection via the sensors of a quench of the one or more HTS current leads;wherein the apparatus further comprises:
latching mechanical switches (210) installed inside the cryostat between the one or more HTS current leads and external current terminals and configured to electrically couple the one or more HTS current leads to one or more devices disposed outside the cryostat; and
wherein the latching mechanical switches **(210)** have an open state and a closed state, and are configured to switch between the open and closed state or vice versa in response to an electrical pulse.

2. The apparatus **(200)** of claim 1, wherein the one or more HTS current leads (206) are formed from Rare earth-Barium-Copper Oxide ReBCO.

3. The apparatus **(200)** of any of claims 1-2, wherein the latching mechanical switches **(210)** in the closed state are configured to remain closed during a power outage.

4. The apparatus **(200)** of any of claims 1-3, wherein the magnet controller **(220)** is configured to prevent the latching mechanical switches **(210)** from opening when they carry current by not executing calls to toggle the latching mechanical switches (210).

5. The apparatus **(200)** of any of the claims 1-4, wherein the one or more sensors **(220)** include voltage sensors and/or temperature sensors.

6. A method **(400)** of protecting high temperature superconductor, hereinafter HTS, leads in a medical imaging device **(100)** from quenching, the method comprising:
measuring a voltage across at least one HTS lead (206);
determining whether the measured voltage is outside of a corresponding predefined threshold;
severing a connection between the at least one HTS lead and electronics (220) of the medical imaging device when the measured voltage is outside of the predefined threshold; wherein the severing includes toggling latching mechanical switches **(210)** from a closed state to an open state in response to an electrical pulse,
the latching mechanical switches electronically connecting the at least one HTS lead **(206)** with the electronics **(220).**

7. The method **(400)** of claim 6, wherein the severing further includes controlling an HTS protection switch (208) for protecting the one or more HTS current leads, to divert current from the at least one HTS lead.

## Patentansprüche

1. Eine Vorrichtung (200), umfassend:
einen Kryostat (202), der ein Volumen kryogener Flüssigkeit enthält;
eine oder mehrere elektrisch supraleitende Spulen (204), die innerhalb des Kryostats angeordnet sind, wobei die eine oder die mehreren elektrisch supraleitenden Spulen so konfiguriert sind, dass sie ein Magnetfeld erzeugen, wenn ein elektrischer Strom durch diese fließt;
eine oder mehrere supraleitende Hochtemperatur-Stromleitungen (206), im Folgenden HTS, die dauerhaft im Kryostat angeordnet und mit einer oder mehreren elektrisch supraleitenden Spulen gekoppelt sind;
einen oder mehrere Sensoren (222), die sich an oder in der Nähe einer oder mehrerer HTS-Stromleitungen befinden und so konfiguriert sind, dass sie den Status der HTS-Stromleitungen überwachen;
einen HTS-Schutzschalter (208) zum Schutz einer oder mehrerer HTS-Stromleitungen, selektiv mit einer oder mehreren HTS-Stromleitungen gekoppelt;
eine Magnetsteuerung (220), die für die Steuerung des HTS-Schutzschalters konfiguriert ist;
wobei der Magnetregler so konfiguriert ist, dass er den HTS-Schutzschalter steuert, dass er Strom von einer oder mehreren HTS-Stromleitungen bei Erkennung eines Quench über die Sensoren der einer oder mehreren HTS-Stromleitungen umleitet; wobei das Gerät weiterhin umfasst:
rastende mechanische Schalter (210), die innerhalb des Kryostats zwischen einem oder mehreren HTS-Stromleitungen und externen Stromanschlüssen installiert und so konfiguriert sind, dass eine oder mehrere HTS-Stromleitungen elektrisch an ein oder mehrere außerhalb des Kryostats angeordnete Geräte gekoppelt werden; und
wobei die rastenden mechanischen Schalter (210) einen offenen und einen geschlossenen Zustand aufweisen und so konfiguriert sind, dass sie in Reaktion auf einen elektrischen Impuls zwischen dem offenen und geschlossenen Zustand oder umgekehrt wechseln.

2. Vorrichtung (200) nach Anspruch 1, wobei die eine oder mehrere HTS-Stromleitungen (206) aus Seltenerd-Barium-Kupferoxid-ReBCO gebildet sind.

3. Vorrichtung (200) nach einem der Ansprüche 1-2, wobei die rastenden mechanischen Schalter (210) im geschlossenen Zustand so konfiguriert sind, dass sie während eines Stromausfalls geschlossen bleiben.

4. Vorrichtung (200) nach einem der Ansprüche 1-3, wobei die Magnetsteuerung (220) so konfiguriert ist, dass sie verhindert, dass sich die rastenden mechanischen Schalter (210) öffnen, wenn sie Strom führen, indem sie keine Aufrufe zum Umschalten der rastenden mechanischen Schalter (210) ausführt.

5. Vorrichtung (200) nach einem der Ansprüche 1-4, wobei der eine oder die mehreren Sensoren (220) Spannungssensoren und/oder Temperatursensoren umfassen.

6. Verfahren (400) zum Schutz von Hochtemperatur-Supraleitern, im Folgenden HTS, in einem medizinischen Bildgebungsgerät (100) gegen das Quenching, das Verfahren umfasst:
Messung einer Spannung an mindestens einer HTS-Leitung (206) ;
Feststellung, ob die gemessene Spannung außerhalb eines entsprechenden vordefinierten Schwellenwerts liegt;
Trennen einer Verbindung zwischen dem mindestens einen HTS-Kabel und der Elektronik (220) des medizinischen Bildgebungsgeräts, wenn die gemessene Spannung außerhalb des vordefinierten Schwellenwerts liegt; wobei die Trennvorrichtung das Umschalten von rastenden mechanischen Schaltern (210) von einem geschlossenen in einen offenen Zustand in Reaktion auf einen elektrischen Impuls umfasst, wobei die rastenden mechanischen Schalter die mindestens eine HTS-Leitung elektronisch (206) mit der Elektronik (220) verbinden.

7. Verfahren (400) nach Anspruch 6, wobei das Trennen des Weiteren die Steuerung eines HTS- Schutzschalters (208) zum Schutz einer oder mehrerer HTS-Stromleitungen umfasst, um Strom von der mindestens einen HTS-Leitung abzuleiten.

## Revendications

1. Appareil (200) comprenant:
un cryostat (202) contenant un volume de fluide cryogénique;
une ou plusieurs bobines électriquement supraconductrices (204) disposées à l'intérieur du cryostat, la ou les bobines électriquement supraconductrices étant configurées pour produire un champ magnétique lorsqu'elles sont traversées par un courant électrique;
un ou plusieurs fils de courant supraconducteurs à haute température (206), ci-après HTS, disposés en permanence à l'intérieur du cryostat et couplés à une ou plusieurs bobines électriquement supraconductrices; un ou plusieurs capteurs (222) placés au niveau ou à proximité du ou des fils de courant HTS et configurés pour surveiller l'état des fils de courant HTS;
un commutateur de protection HTS (208) pour protéger un ou plusieurs fils de courant HTS, couplé sélectivement à un ou plusieurs fils de courant HTS;
un contrôleur magnétique (220) configuré pour commander le commutateur de protection HTS;
dans lequel le contrôleur magnétique est configuré pour commander le commutateur de protection HTS afin de détourner le courant d'un ou de plusieurs fils de courant HTS lors de la détection par les capteurs d'une trempe d'un ou de plusieurs fils de courant HTS; dans lequel l'appareil comprend en outre:
des interrupteurs mécaniques à verrouillage (210) installés à l'intérieur du cryostat entre le ou les fils de courant HTS et les bornes de courant externes et configurés pour coupler électriquement le ou les fils de courant HTS à un ou plusieurs dispositifs disposés à l'extérieur du cryostat; et
dans lequel les interrupteurs mécaniques à verrouillage (210) ont un état ouvert et un état fermé, et sont configurés pour passer de l'état ouvert à l'état fermé ou vice versa en réponse à une impulsion électrique.

2. Appareil (200) selon la revendication 1, dans lequel le ou les fils de courant HTS (206) sont formés d'oxyde de cuivre, de baryum et de terre rare ReBCO.

3. Appareil (200) selon l'une des revendications 1-2, dans lequel les interrupteurs mécaniques à verrouillage (210) à l'état fermé sont configurés pour rester fermés pendant une panne de courant.

4. Appareil (200) selon l'une des revendications 1-3, dans lequel le contrôleur magnétique (220) est configuré pour empêcher les interrupteurs mécaniques à verrouillage (210) de s'ouvrir lorsqu'ils sont alimentés en courant en n'exécutant pas d'appels pour faire basculer les interrupteurs mécaniques à verrouillage (210) .

5. Appareil (200) selon l'une des revendications 1-4, dans lequel le ou les capteurs (220) comprennent des capteurs de tension et/ou des capteurs de température.

6. Méthode (400) de protection des fils supraconducteurs à haute température, ci-après HTS, dans un dispositif d'imagerie médicale (100) contre la trempe, la méthode comprenant les étapes consistant à: mesurer une tension entre au moins un fil HTS (206); déterminer si la tension mesurée est en dehors d'un seuil prédéfini correspondant; couper la connexion entre au moins un fil HTS et l'électronique (220) de l'appareil d'imagerie médicale lorsque la tension mesurée est en dehors du seuil prédéfini; où le sectionnement comprend le basculement des interrupteurs mécaniques à verrouillage (210) d'un état fermé à un état ouvert en réponse à une impulsion électrique, les interrupteurs mécaniques à verrouillage connectant électroniquement l'au moins un fil HTS (206) à l'électronique (220).

7. Méthode (400) selon la revendication 6, dans laquelle le sectionnement comprend en outre la commande d'un interrupteur de protection HTS (208) pour protéger un ou plusieurs fils de courant HTS, afin de détourner le courant du au moins un fil HTS.
